# EUROPEAN PATENT APPLICATION

(11) **EP 4 821 589 A1**
(43) Date of publication of application: **14.10.2026**
(21) Application number: 26171406.7
(22) Date of filing: 09.04.2026
(51) Int. Cl.: B01F 27/1111

(54) **RUSHTON AGITATOR, AND AN APPARATUS AND A METHOD FOR INHIBITING PROCESS SCALE BUILD-UP ON A RUSHTON AGITATOR**

(30) Priority: 09.04.2025 US 202563785860 P
(71) Applicant: Hatch Ltd., Mississauga, Ontario L5K 2R7 (CA)
(72) Inventor: ZUNTI, Lyle Patrick, Burlington, L7R (CA)
(74) Representative: LKGLOBAL Partnerschaftsgesellschaft mbB

(57) **Abstract**

A Rushton impeller, an agitator, and a method for operating a Rushton impeller in a fluid. The Rushton impeller 400 comprises a hub 430, blades 410 radially distributed about the hub for rotating about the centreline of the impeller to move a fluid radially. The inner edges of the blades are spaced a distance from the centreline of the impeller. The impeller comprises a non-convex bevel 450 between the hub and the blades, the bevel encircling the centreline of the impeller and rotating with blades. The impeller may rotate in a fluid to induce movement in the fluid and inhibit the formation of low fluid velocity regions in a region between the centreline of the impeller and the blades. The agitator may comprise the Rushton impeller, a motor, and a shaft driven by the motor.

## Description

### FIELD

The present disclosure relates generally to impellers and agitators.

### BACKGROUND

A Rushton agitator (also known as a Rushton impeller, Rushton turbine, or flat blade disc turbine) is an agitator that uses a blade disk radial impeller, for generating radial flow in a fluid. Rushton agitators are often used in fluid mixing arrangements for process tanks and vessels, for example, in the chemical and/or mineral processing industries.

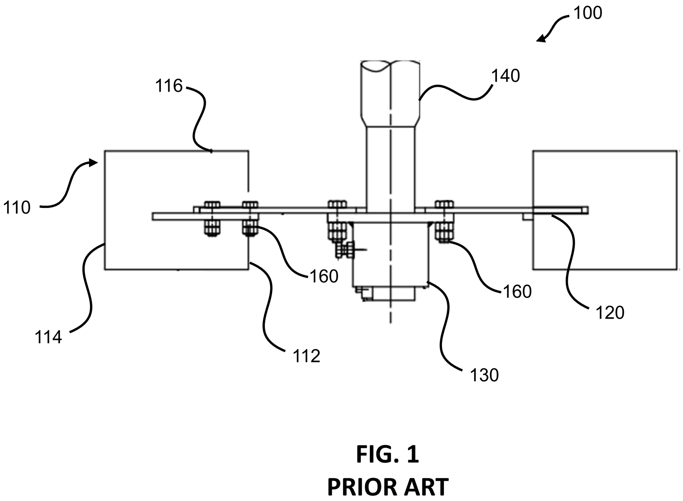

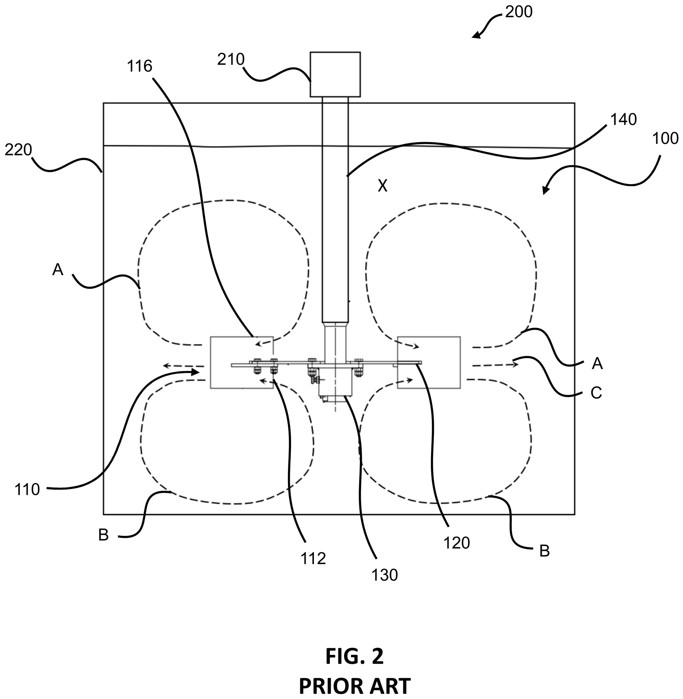

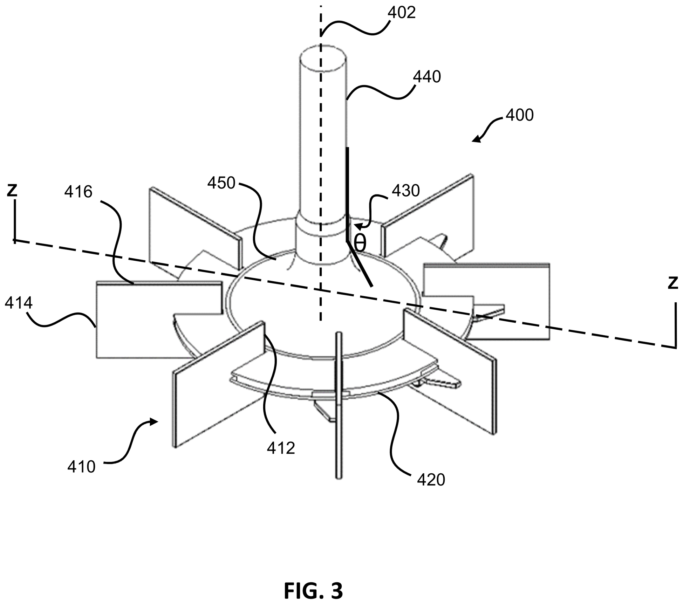

**FIGs. 1** and **2** show side views of a Rushton impeller 100 as part of an agitator 200 (Fig. 2, only) and the corresponding fluid dynamics according to prior art. The Rushton impeller 100 has blades 110 (also referred to as fins) connected to a flat disk 120. The flat disk 120 is mounted to a hub 130, the hub 130 is connected to a shaft 140, and the shaft 140 is mounted to a motor and/or gearbox 210 to form an agitator 200 (Fig. 2, only). The motor and/or gearbox may be situated outside of the tank or vessel 220 for the agitator to provide the rotational motive power to the impeller for generating radial fluid flow of the fluid that is being mixed in the tank or vessel (as shown particularly in FIGs. 2 and 3).

FIG. 2 depicts a cross-sectional front view of an agitator 200 comprising the Rushton impeller 100 of FIG. 1. During operation, the Rushton impeller 100 causes the fluid within the agitator 200 to flow in the direction generally shown by radial fluid flow paths A and B.

However, during operation of a Rushton agitator, material within the solution being mixed by the agitator can accumulate on and/or below the impeller and agitator components, for example, on and/or around the flat disk, the hub, the blades (including around the inner edges of the blades and between the blades), and/or the shaft. This material build up (also referred to as scale) on the agitator components can promote additional precipitate / material accumulation. A scaled agitator can affect the process mixing, chemical reactions, mass transfer, and/or other process parameters that can result in a reduced processing capacity and/or lost material recovery. In addition, scale on the agitator and/or impeller components can structurally and/or chemically degrade or wear down the agitator components, which may reduce their lifetime resulting in eventual replacement for new components. In some cases, the mass of the scale on the agitator or impeller components can lead to equipment breakage due to the weight and/or imbalanced rotating loads on the equipment. Removing the scale and cleaning the agitator components often requires costly shutdowns. Radial fluid flow is different than axial fluid flow. Some impellers are configured to cause axial fluid flow and not radial fluid flow. Axial fluid flow is wherein the fluid travels parallel to the axis of rotation of the impeller. Radial fluid flow is wherein the fluid travels perpendicular to the axis of rotation of the impeller. Axial fluid flow impellers may not suffer from the same foregoing scale accumulation issues as radial fluid flow impellers.

Accordingly, systems, apparatus, and methods for reducing material build up on Rushton agitator components is desired.

### SUMMARY

The present invention is for a Rushton impeller, apparatus, and method for an agitator. The invention comprises a bevel that is configured to help conform to the flow paths developed within a fluid velocity region between a hub and blades. The bevel surrounds the hub, or shaft, or a defined centerline of the impeller about which the impeller rotates. The bevel rotates about the centreline of the impeller, including as a hub or shaft rotates thereabout. In an embodiment, the bevel rotates along with the hub/shaft and blades at their same rate. The bevel may be around the impeller components and/or the related connecting components, such as the components of an agitator or other device that uses a blade disk radial impeller. The bevel is positioned between the hub/shaft and the blades. The bevel may extend between the hub/shaft and the blades. The bevel may comprise a slope that is diagonal between the centreline of the impeller and the blades. The bevel may define an approximately non-convex surface. In other words, the bevel may be an approximately linear surface, or the bevel may be an approximately concave surface. The bevel may radially extend from the centreline of the impeller towards the blades. In the example of an agitator in accordance with the present invention, the bevel may extend from the hub or shaft toward the impeller blades. The bevel may be on the top and/or bottom of the impeller. The bevel may be positioned above and/or below a blade disk of the impeller. The bevel may comprise a plurality of bevels. The plurality of bevels may comprise a first bevel about the blade disk, and a second bevel below the blade disc.

In an embodiment of the present invention, the bevel may be configured to help inhibit low velocity fluid regions near the shaft disc interface where material accumulation may be prone to precipitate and/or without substantially disrupting the radial fluid flow of the Rushton impeller. In another embodiment of the present invention, the bevel's surface may be positioned in an area / zone of fluid velocity within the tank/vessel such that the fluid therein may scrub the bevel surface, which may inhibit material accumulation. Positioning the bevel's surface in a non-zero fluid velocity region of the impeller flow may also or alternatively reduce the area / volume for scale to accumulate on the impeller components.

### BRIEF DESCRIPTION OF THE FIGURES

Embodiments of the present disclosure will now be described, by way of example only, with reference to the attached Figures.
**FIG. 1** depicts a cross-sectional side view of a Rushton impeller 100, according to prior art.
**FIG. 2** depicts a cross-sectional side view of an agitator 200 comprising the Rushton impeller 100 of FIG. 1, and a schematic showing radial fluid flow paths A,B, and C according to prior art.
**FIG. 3** depicts an isometric view of a Rushton impeller 400 affixed to a shaft 440, according to an embodiment of the present invention.
**FIG. 4** depicts a representation of the fluid dynamics of a Rushton impeller.
**FIG. 5** depicts a cross-sectional view of the Rushton impeller 400 of FIG. 3 along cut-line Z-Z.
**FIG. 6** depicts a cross-sectional view of a Rushton impeller 600, where the blades 610 are affixed to the bevel 650, according to an embodiment.
**FIG. 7** depicts a computational fluid dynamics (CFD) diagram of a cross-sectional view of a Rushton impeller 700 with a bevel 750 and complementary bevel 752, according to an embodiment.
**FIGs. 8A, 8B, and 8C** depict a bevelled flange 854 as a solid piece or multiple pieces, according to embodiments.
**FIG. 9** depicts low fluid velocity regions 970 in a CFD diagram of a Rushton impeller 900.
**FIGs. 10A-10I** depict cross-sectional views of a Rushton impeller 1000 comprising bevels with different shapes or profiles, according to embodiments of the present invention.
**FIG. 11** depicts a cross-sectional front view of a Rushton impeller 1100 with an upper impeller 1180 affixed above the impeller 1100 on a shaft 1180 according to an embodiment of the present invention.
**FIG. 12** is a block diagram of a method 1200 for operating a Rushton impeller in a fluid according to an embodiment of the present invention.

### DETAILED DESCRIPTION

**FIG. 1** shows a side view of a Rushton impeller 100 according to the prior art. The impeller 100 has blades 110 radially distributed around a hub 130. The blades have inner edges 112, top edges 116, and outer edges 114. The blades 110 and the hub 130 are each affixed to a flat disk 120, for example, using mechanical fasteners 160. The disk 120 and/or hub 130 may be affixed to the shaft 140 of an agitator 200 (not shown). The quantity of blades 110 may generally range from 4 blades to 8 blades.

**FIG. 2** shows the Rushton impeller 100 of FIG. 1 as part of an agitator 200. The shaft 140 of the agitator 200 is connected to a gearbox / motor 210, which is typically located outside of the agitated tank or vessel 220. The gearbox 210 provides the rotational motive force to turn the impeller 100 for mixing one or more fluids in the agitator 200. The Rushton impeller 100-also known as a flat blade disk impeller or radial impeller-generates radial flow in the fluid X within the tank/vessel 220 for mixing, and/or gas dispersion, in which the fluid(s) X generally moves outward C from the blades 110 and then up A and / down B, inward A and B, and back down A / up B, toward the impeller 100 to mix the fluid(s) per fluid paths A and B.

The blades 110 of the Rushton impeller 100 are positioned such that a portion of each blade 110 extends above and below the disk 120 (or horizonal centreline of the impeller 100, which may be in the same or different horizontal plane as the disk 120). This positioning of the blades 110 allows for the generation of the two fluid paths A and B forming two recirculation zones (one on the top and one on the bottom of the agitator relative to the position of the impeller 100). If the blades 110 only extended above the disk 120, the impeller 100 would primarily only generate fluid path A that has radial fluid flow to form the top circulation zone shown in FIG. 2. Similarly, if the blades 110 only extended below the disk 120, the impeller 100 would primarily only generate fluid path B with radial fluid flow to form the bottom circulation zone shown in FIG. 2. In the vessel 220 of Rushton agitator 200, two circulation zones formed by radial or approximately radial fluid flow generated by a Rushton impeller 100 may be used to help promote even mixing of the fluid(s) in the agitator 200 and/or help inhibit material build up on the bottom of the agitator 200. The Rushton impeller 100 blades 110 may be symmetric above and below the disk 120. In some applications, Rushton impeller 100 blades 110 may be asymmetric above and below the disk 120, for example, depending on the location of the impeller 100 in the vessel 220 of the agitator 200. The Rushton impeller 100 may be positioned in the agitator 200 such that there is approximately even mixing of the fluid(s) in the vessel 220 of the agitator 200.

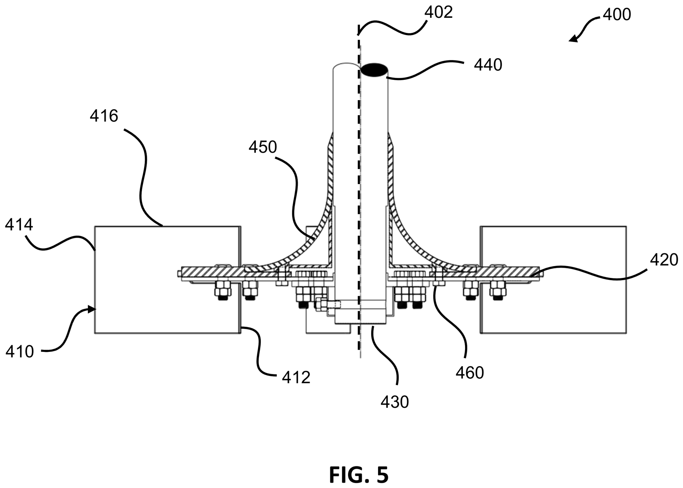

**FIG. 3** and **FIG. 5** show a perspective view and a cross-section side view of a Rushton impeller 400 comprising a bevel 450 according to the present invention. The bevel 450 may be affixed to the shaft 440 of an agitator (not shown).

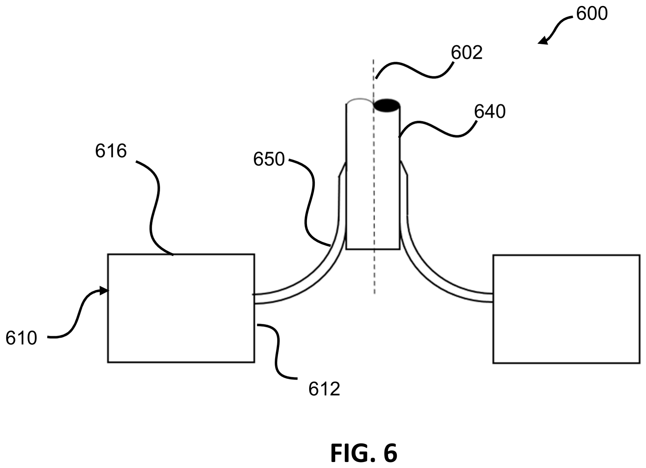

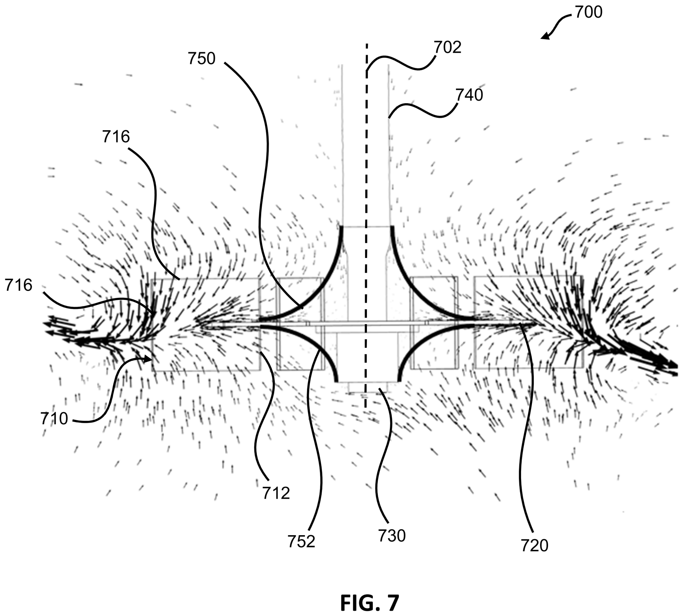

The bevel 450 may be a profile or a surface, which may be sloped, flat, and/or of varying curvature. The Rushton impeller 400 may comprise a hub 430 and blades 410 radially distributed around the hub 430. The centreline 402 of the impeller 400 may also be the centreline of the hub 430. The blades are for mixing a fluid within the agitator. The blades comprise an inner edge 412, an outer edge 414, and a top edge 416. The inner edge 412 of the blades 410 may be spaced a distance from the centreline 402 of the impeller 400. The inner edges 412 of the blades 410 may extend beyond the bevel 450, or beyond a surface of the bevel 450 (e.g., the beveled edge or beveled surface of the bevel 450). At least a portion of an inner edge 412 of the blades 410 may extend beyond the bevel 450 such that the top edge 416 of the blades 410 does not intersect with bevel 450 (e.g., the bevel 450 intersects the inner edge 412 of the blade a distance away from the top edge 416). In some embodiments, the blades 410 (or an inner edge 412 of the blade 100) may not extend to the shaft 440 or the hub 430. The impeller 400 may comprise a disk 420 to which the blades 410 may be attached. The bevel 450 may be positioned above or below the disk 420. The blades 410 may be attached directly to the bevel 450 (as shown, for example, in **FIG. 6**). In this way, the impeller 400 may comprise no disc 420, or the bevel may transition into the disc, or the bevel may itself comprise a disc. The bevel 450 may be positioned on the top and/or on the bottom of the impeller 400 (as shown for example in FIG. 7).

The bevel 450 may be affixed to a Rushton impeller 400, agitator, or components thereof using mechanical fasteners 460, such as screws, nuts, and bolts. The bevel 402 may also or alternatively be affixed using chemical and/or physical methods, such as welding or adhesives. The bevel 450 may be affixed such that the bevel 450 rotates with one or more components of the impeller 400. For example, the bevel 450 may be affixed to the shaft 440 or hub 430 such that the bevel 450 rotates with the shaft 440 or hub 430 of the impeller 400. The bevel 450 may be affixed to the blades 410 such that the bevel rotates with the blades 410 of the impeller 400. The bevel 450 may be affixed to the shaft 440 or hub 430 for the bevel to intersect the shaft 440 or hub 430 at an obtuse angle θ (i.e., greater than 90 degrees). Providing a bevel 450 that intersects the shaft 440 or hub 430 (which are typically positioned vertically or approximately vertically in an agitator vessel) at an obtuse angle may also help inhibit material accumulation in low velocity regions and/or on the bevel 450 itself.

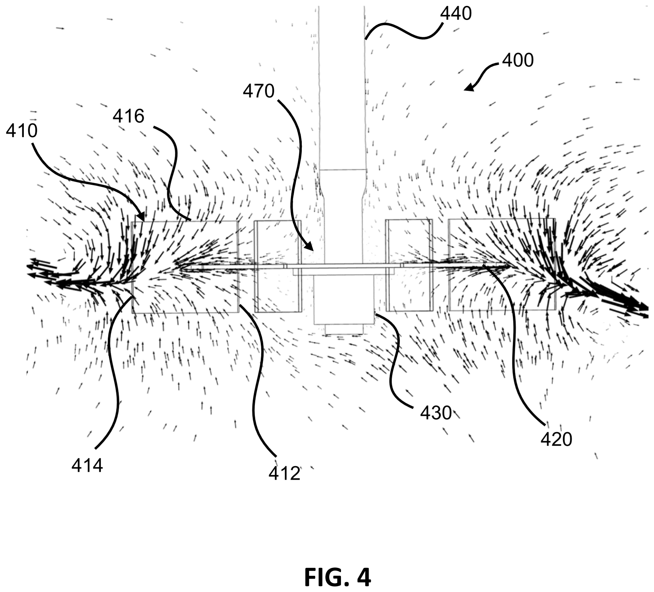

**FIG. 4** shows a computational fluid dynamics (CFD) diagram of a Rushton impeller. As shown in Fig. 4, the fluid velocity may be higher near the outer edges 414 of the impeller blades 410 and may be lower closer to hub 430 of the impeller 400. Low fluid velocity regions 470, such as in the space between the inner edges 412 of the blades 410 and the hub 430 (or shaft 440), may have material accumulation (e.g., scale build-up) over time. This material accumulation may occur in regions where there is a flat surface or convex surface. Once some material builds up on a surface or component of the impeller 400, it may promote or precipitate further build up on the existing material accumulation, such that over time larger amounts of material accumulates at an increasing rate of accumulation, including over other components of the impeller 400.

**FIG. 6** shows an impeller 600 comprising bevel 650 affixed to the blades 610. The bevel 650 intersects with the shaft 640. The bevel 650 retains the blades to the shaft 640. The bevel intersects the shaft at an obtuse angle. The bevel 650 is non-convex. The inner edges 612 of the blades 610 extend above and below the bevel 650. The top edge 616 of the blades 610 may not intersect with the bevel 650.

Referring to **FIG. 7****,** a second, complementary bevel 752 may extend from another location of the impeller 700 toward the inner edges 712 of the blades 710. The complementary bevel may not intersect with the top edges 716 of the blades 710. The complementary bevel 752 may be opposite to the bevel 750. For example, if the bevel 750 is positioned above a defining centre axis, then the complementary bevel 752 may be positioned below the defining centre axis and similarly extend toward the inner edges 712 of the blades 710. The complementary bevel 752 may be sized and shaped to be the same as, or different from, the bevel 750. Embodiments described herein regarding the bevel 750 may similarly describe embodiments of the complementary bevel 752.

The bevel in accordance with the present invention may be a conical continuous surface forming a plane. The bevel may have an approximately flat, flat, or concave frustoconical shape. The bevel may be non-convex or have a non-convex profile, where non-convex means generally flat, flat, or concave. The non-convex bevel may help inhibit fluid from flowing in a low fluid velocity region. The low fluid velocity region may comprise the region between the hub or centreline of the impeller and the blades. Inhibiting fluid from flowing within such region(s) may help prevent material build up in the region on components of the impeller. The non-convex bevel may help inhibit material build up on the bevel itself, for example, the non-convex bevel may help material slide / fall off or be scrubbed off the surface of bevel with the fluid. The non-convex bevel may be shaped to conform to the approximate fluid flow profile of the impeller in the absence of a bevel. For example, the non-convex bevel may be shaped to approximately align with the radial fluid flow and convectional flow of the fluid in a Rushton impeller or agitator with a Rushton impeller.

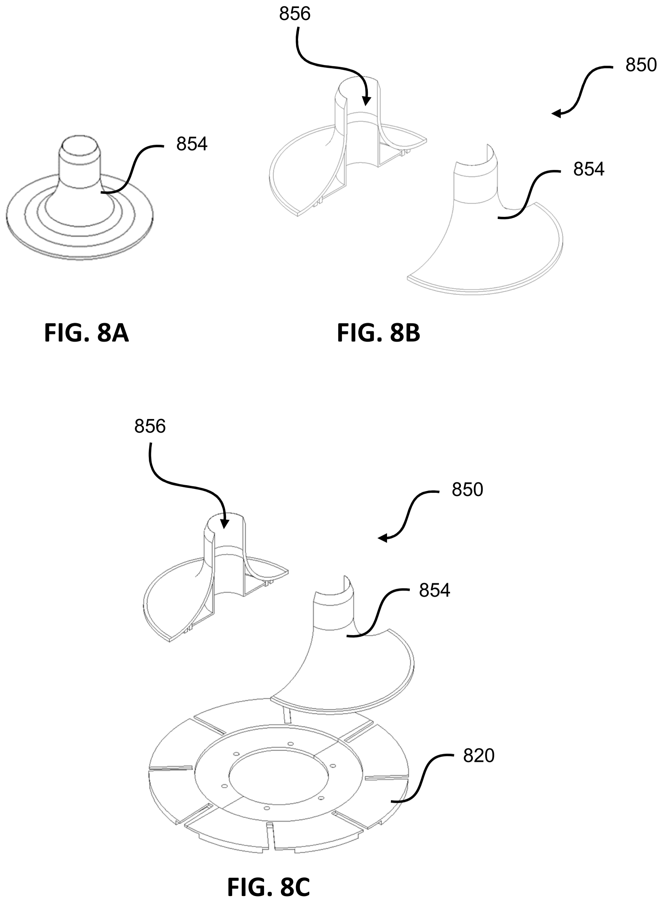

Referring to **FIG. 8A, FIG. 8B, and FIG. 8C****,** the bevel 850 may be formed to result in continuous circular piece or flange854. The bevel 850 may also comprise two half bevels which, when put together, form a single circular bevel. The bevel may be affixed to a shaft of an agitator connected to a Rushton impeller (not shown). The bevel 850 may be affixed to a hub or disk 820 of a Rushton impeller. The bevel may intersect the shaft at an obtuse angle to help inhibit material build up on the impeller or the bevel itself. The bevelled flange(s) 854 may be affixed to the Rushton impeller 100 of the prior art, such as in FIG's 1-3. The bevelled flange(s) 854 may have an opening 856 to receive and encircle the shaft of an agitator (not shown). The bevelled flange(s) 854 may be a single piece affixed to a Rushton impeller and/or shaft, or the bevelled flange(s) 854 may be an assembly of one or more pieces that form the bevelled flange 854 as shown, for example, in FIG. 8B and FIG. 8C, comprising two half-flanges, which may facilitate installation of the bevelled flange 854 on a Rushton impeller / shaft. For example, some vessels may have a nozzle or vessel opening that is too small to fit the impeller components whole, and thus the bevel 850 / bevelled flange 854 may be installed on the impeller (not shown) in pieces sized to fit through the vessel nozzle or opening. Manufacturing the bevel 850 / bevelled flange 854 in pieces may be preferable for other reasons, such as manufacturing conditions/limits and/or cost.

In other cases, the Rushton impeller may be manufactured as a solid piece that includes the bevel 450, or a component of the Rushton impeller may be manufactured as a hollow piece that includes the bevel 450. For example, the hub 430 or the disk 420 may be a solid piece manufactured in shape to have the bevel 450. In an agitator, the shaft 440 may be manufactured in shape to have the bevel 450 for affixing to an impeller.

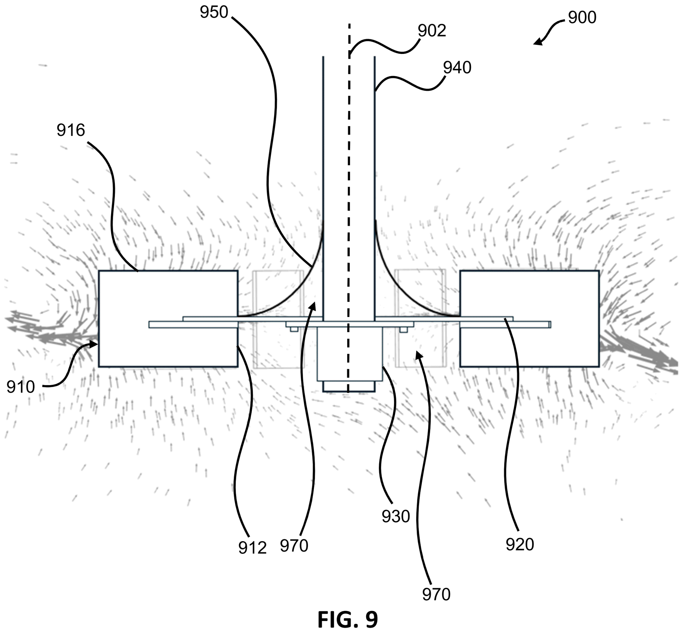

**FIG. 9** shows a CFD diagram of a Rushton impeller 900 on which a bevel 950 according to the present invention is superimposed to illustrate an example shape and position of the bevel 950 on the impeller 900 according to one or more embodiments. The bevel 950 is shaped and positioned to conform with the contour of a low fluid velocity region 970 in the space between the inner edges 912 of the blades 910 and the impeller centreline 902. The bevel 950 is non-convex. The bevel 950 intersects the hub 940 at an obtuse angle to the shaft. The bevel 950 intersects the blades 910 at a distance above and/or below from the top edges 916 of the blades. In the example shown in FIG. 9, where the impeller is affixed to the shaft 940 of an agitator, the low fluid velocity region 970 may be in a space between the inner edges 912 of the blades and the shaft 940. The low fluid velocity region 970 may be near the intersection of the hub 930 and the shaft 940 and/or the disk 920. The low fluid velocity region 970 may be above and/or below the rotational plane of the blades 910. Additional low velocity regions 970 may exist, according to the geometry and/or operating conditions of the impeller 900. For example, low fluid velocity regions 970 may occur near other parts of the impeller 900 or an agitator, such as the hub 930, the shaft 940, and/or the inner portion of disk 920.

The position and/or shape of the bevel 950 may be configured to inhibit fluid from flowing to the low fluid velocity region(s) 970 according to the profile of the low velocity region(s) 970, which may depend on the geometry or configuration of the Rushton impeller 900, such as the size of each component and/or the blade type. The location of the bevel 950 may depend on the operating conditions of the impeller 900 and/or, for example, the operating conditions of an agitator, such as the process conditions (temperature, pressure, rotation speed) and/or the composition and properties of the fluid(s) being mixed.

The bevel 950 may be positioned or extend into a non-zero fluid velocity region to help impart fluid velocity to the surface of the bevel 950 when it rotates with the impeller 900. In an embodiment, the kinetic energy of the fluid causes the fluid and the bevel 950 to come into contact with one another at different speeds. For example, the bevel 950 may be positioned where the fluid velocity is at least greater than approximately 0.5 m/s for the flow of the Rushton impeller 900. The fluid flow near or on the surface of the bevel 950 at the non-zero fluid velocity region may help scrub the surface of the bevel 950 to help inhibit material accumulation thereon. For example, the fluid flow may help move material away from the surface of the bevel 950 to help inhibit material accumulation on the bevel 950 and/or other components. The bevel 950 may be shaped or formed as suitable such that the fluid in the non-zero fluid velocity scrubs or flows over the bevel surface and/or such that the bevel inhibits fluid from entering the space between the inner edges 912 of the blades 910 and the impeller centreline 902; in FIG. 9 the space with a low velocity fluid region 970 includes the space between the inner edges 912 of the blades 910 and the shaft 940. The bevel 950 surface may be smooth. The bevel surface may be non-smooth, including comprising ridges, grooves, curves, and/or fins. The induced flow may affect or may not affect the radial flow of the impeller 900.

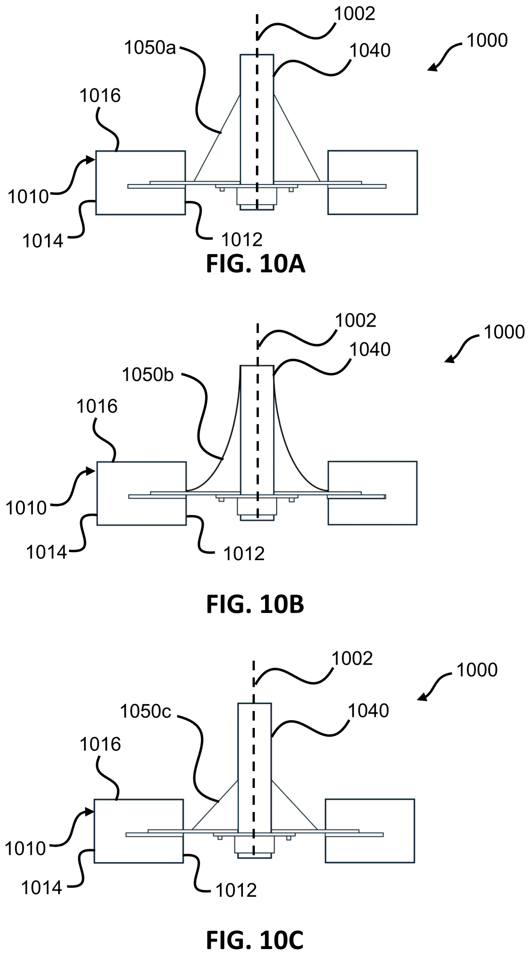

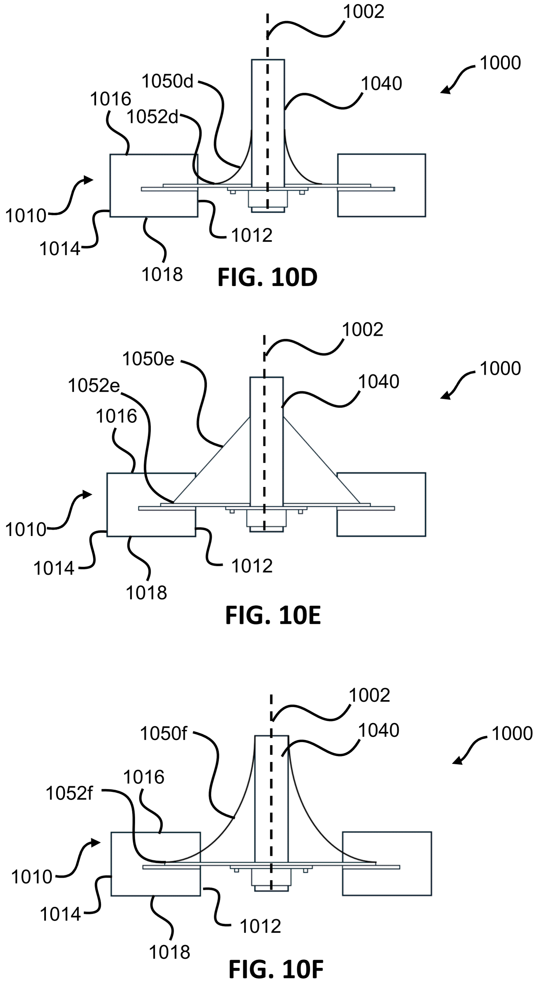

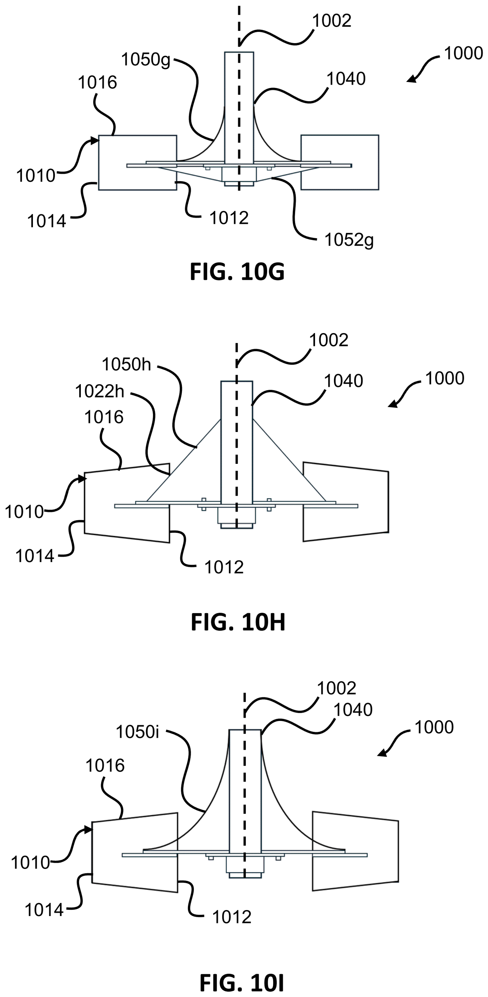

**FIGs. 10A-10I** show representative examples of a Rushton impeller 1000 comprising a bevel 1050a-i in accordance with embodiments of the present invention. The bevel may have any shape, profile, or cross-section suitable for helping inhibit fluid from flowing into the low fluid velocity zone(s). The bevel 1050 may be shaped to have a cross-section that is linear (see, e.g., FIG. 10A; bevel 1050a), concave (see e.g., FIG. 10B; bevel 1050b), or any combination of linear, stepped, parabolic, and/or curved elements that form an approximately linear, stepped, parabolic, or concave cross-section. The outer circumference dimension of the bevel 1050 increases as the bevel 1050 extends toward the blades 1010. The bevel 1050 may be cone shaped, approximately coned shape, or frustoconical. The bevel 1050 may terminate at a position between the top edges and bottom edges of the blades 1010 (see FIG. 10B, for example). The bevel 1050 may extend to the inner edges 1012 of the blades 1010 (see FIG. B, for example) and/or past the inner edges 1012 of the blades 1010 (see FIG. 10F, for example). The bevel 1050 may comprise an outermost edge (see 1050d, 1050e, 1052f, for example), wherein the outermost edge of the bevel terminates before the outer edge 1014 of the blades 1010 (see FIGs. 10D, 10E and 10F, for example). The outermost edge of the bevel (see 1050d, 1050e, 1052f, for example) may terminate between the inner edges 1012 and the outer edges 1014 of the blades 1010 (see FIGs. 10E and 10F, for example). The bevel 1050 may intersect the inner edges 1012of the blades 1010 (see FIG. 10B, for example). The bevel 1050 may intersect the inner edges 1012 of the blades 1010 at a distance from the top edge 1016 of the blades 1010 and/or at a distance from the bottom edge of the blades 1010 (see FIG. 10E, for example). The bevel 1050 may extend to and/or past the outer edges 1014 of the blades 1010. The bevel 1050 may extend radially outward from the centerline toward the blades 1010. The bevel 1050 may not fully reach the inner edges 1012 of the blades 1010 (see FIGs. 10C and 10D, for example). The bevel 1050 may extend from the blades 1010 or a position near the blades 1010 toward the impeller centreline 1002. Where the impeller comprises a bevel and a complementary bevel, the complementary bevel may be the same or different (see FIG. 10G, for example) than the bevel. In an embodiment, the outermost edge of the bevel (1052e, for example) terminates both below an upper edge 1016 of the blades 1010 and below a lower edge 1018 of the blades 1010 (see Fig. 10E, for example) such that the blades 1010 extend above and below the outermost edge of the bevel.

The bevel 1050 may contact a hub 1030 and/or shaft 1040, or the bevel 1050 may extend toward, but not fully reach the hub 830 and/or shaft 840 (see FIG. 10D, for example). The bevel 1050 may extend non-uniformly from and/or to the hub 830 and/or shaft 840. For example, the bevel 1050 may extend further outward at some points compared to other points, e.g., the bevel 1050 may extend further toward the blades 1010 than it does toward the empty regions between the blades 1010. The bevel 1050 may extend past the inner edges 1012 of the blades 1010 such that the bevel 1050 intersects at a midpoint 1022h of the inner edges of the 1012 of the blades 1010 (see FIG. 10H, for example).

The bevel may be any combination of an upper bevel (e.g., bevel 1050a-i) and a lower bevel (e.g., complementary bevel 1052g in FIG. 10G), for example as shown in FIG 7 and FIG 10G. The blades of the impeller may be modified in size and shape to accommodate the shape of the bevel, for example, as shown in FIGs. 10H and 10I. For example, the blades 1010 may be shaped such that the intersection of the top edge 1016 and inner edge 1012 extends a distance above the point where the bevel 1050 intersects with the inner edge 1012. The blades 1010 may be shaped to maintain approximately an equal distance between the upper edge 1016 of the blades and the bevel 1050 (or the surface of bevel 1050) where the bevel 1050 intersects the blades 1010. Other profiles of the bevel 1050 are possible that are suitable for a given context, according to, e.g., the impeller 1000, agitator, process, and/or a desired fluid flow profile.

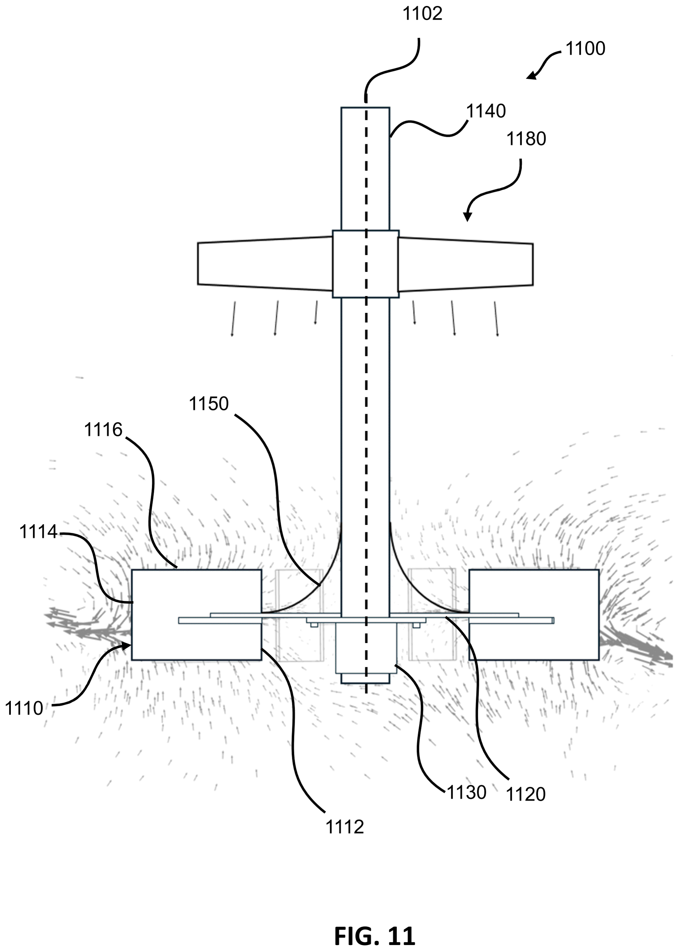

Referring to **FIG. 11****,** an upper axial impeller 1180 may be configured to provide downward or approximately downward fluid flow toward the Rushton impeller 1100, which may include increasing the fluid velocities in the downward direction. The downward fluid flow may induce and/or increase scrubbing of the surface of the bevel 1150 to help inhibit material accumulation on the bevel 1150 and/or impeller 1000 components. The upper impeller 1180 may be affixed to an agitator (not shown), e.g., on the shaft 1140, at a position above the Rushton impeller 1100 such that the upper impeller rotates with the blades 1110. The upper impeller 1180 may be any impeller suitable for providing additional fluid flow or increased fluid velocities toward the bevel 1150 and/or the Rushton impeller 1100.

The bevel and impeller according to any of the foregoing embodiments may be composed of any material(s) suitable for an impeller, vessel, agitator, other device and/or the process(es) for which the impeller with the bevel may be used, including factors such as temperature, pressure, and solution chemistry (e.g., acidity). For example, the bevel may be composed of solid plastic, polytetrafluoroethylene (PTFE), metal (e.g., titanium, stainless steels, carbon steels), or any other material suitable for the context. The bevel and/or components of the Rushton impeller, agitator, vessel, or other device may be coated with a material, for example, to protect the component(s) from abrasion and/or to help inhibit material accumulation on the component(s). For example, the coating may be an abrasion protective coating (e.g., ceramic) and/or a non-stick coating (e.g., hydrophobic, oleophobic, etc.) or any other functional coating suitable for the context.

The Rushton impeller according to any of the foregoing embodiments may be in any configuration suitable for a radial impeller. The blades may be perpendicular or at an angle to their rotational plane. The blades may be in contact with the bevel, the hub, and/or the disk. The blades may be flat, curved, scooped, forward swept, and/or back swept. The blades may be flat to help increase the shear forces to mix the fluid(s), for example, to help atomize gas and/or to help increase mass transfer in the agitator vessel. The blades of the impeller may by extend above and below the edge of the bevel that terminates at the blades, the hub and/or the disk. The blades of the impeller may by extend symmetrically or asymmetrically above and below the edge of the bevel that terminates at the blades, the hub, and/or the disk.

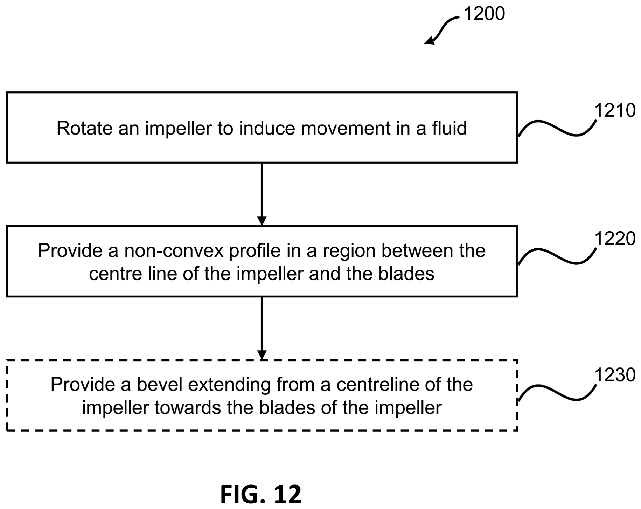

**FIG. 12** is a block diagram of a method 1200 for operating a Rushton impeller.

At 1210, the impeller may be rotated to induce movement in a fluid. The fluid may be any fluid suitable for the given process and contained within any vessel suitable for the process. For example, the impeller may be part of an agitator.

At 1220, a non-convex profile according to any of the embodiments described herein may be provided in the low velocity fluid region between the centre line of the impeller and the blades.

At 1230, a bevel according to any of the embodiments described herein may be provided that extends from a centreline of the hub towards inner edges of the blades of the impeller. The bevel may inhibit fluid from entering a space between inner edges of blades of the impeller and a hub of the impeller. The space may be a low fluid velocity region, as previously described in the present disclosure.

The embodiments described herein are intended to be examples only. Alterations, modifications and variations can be effected to the particular embodiments by those of skill in the art. The scope of the claims should not be limited by the particular embodiments set forth herein but should be construed in a manner consistent with the specification as a whole.

The following examples also form part of the present disclosure:
1. A Rushton impeller comprising:
   a hub;
   blades radially distributed about the hub for rotating about a centreline of the impeller to move a fluid radially, the blades having an inner edge spaced a distance from a centerline of the impeller; and
   a non-convex bevel between the hub and the blades, the bevel encircling the centreline of the impeller and rotating with the blades.
2. The Rushton impeller of example 1, wherein the non-convex bevel extends from the hub toward the blades.
3. The Rushton impeller of examples 1 or 2, wherein all the blades are the same size and shape.
4. The Rushton impeller of any one of examples 1 to 3, wherein the bevel extends from the hub to the blades.
5. The Rushton impeller of any one of examples 1 to 4, wherein at least a portion of the blades extend beyond the bevel.
6. The Rushton impeller of example 5, wherein the bevel comprises an outermost edge, and wherein the outermost edge of the bevel terminates prior to the outermost edge of the blades.
7. The Rushton impeller of any one of examples 1 to 6, wherein the bevel comprises an outermost edge, and wherein the outermost edge of the bevel terminates below an upper edge of the blades, and above a lower edge of the blades.
8. The Rushton impeller of any one of examples 1 to 7, wherein the bevel is at an obtuse angle to a shaft or the hub.
9. The Rushton impeller of example 8, wherein the bevel intersects the shaft or the hub at the obtuse angle.
10. The Rushton impeller of any one of examples 1 to 9, wherein an edge of the bevel terminates about the centerline.
11. The Rushton impeller of any one of examples 1 to 10, wherein the bevel is shaped to comprise a concave cross-sectional profile.
12. The Rushton impeller of any one of examples 1 to 10, wherein the bevel is shaped to comprise a linear cross-sectional profile.
13. The Rushton impeller of any one of examples 1 to 12, further comprising a flange or a sheet configured to provide the bevel.
14. The Rushton impeller of example 1, wherein the bevel is mechanically fastened or welded to the hub.
15. The Rushton impeller of example 1, wherein the bevel is an assembly of one or more pieces.
16. The Rushton impeller of any one of examples 1 to 15, wherein the bevel affixes the blades to the hub.
17. The Rushton impeller of any one of examples 1 to 16, further comprising a disk connecting the blades to the hub, wherein the bevel covers at least a portion of a surface of the disk between the hub and the blades.
18. The Rushton impeller of any one of examples 1 to 17, wherein the bevel extends past the inner edge of the blades.
19. The Rushton impeller of any one of examples 1 to 18, wherein the blades are perpendicular to their rotational plane.
20. The Rushton impeller of any one of examples 1 to 19, wherein the blades are at an angle to their rotational plane.
21. The Rushton impeller of any one of examples 1 to 20, wherein the blades are in contact with the bevel.
22. The Rushton impeller of any one of examples 1 to 21, wherein the blades are flat, curved, scoops, forward swept, or back swept.
23. The Rushton impeller of any one of examples 1 to 22, further comprising an upper impeller positioned a distance above the blades to increase downward fluid velocity against the bevel.
24. The Rushton impeller of any one of examples 1 to 23, further comprising a complementary bevel extending from another location of the centerline of the hub toward the blades, wherein the complementary bevel is on an opposite side of a rotational plane of the blades as the bevel.
25. The Rushton impeller of any one of examples 1 to 24, the bevel further comprising a protective coating for inhibiting abrasion or a non-stick coating.
26. An apparatus for a radial impeller comprising blades configured to induce a radial flow of a fluid, the apparatus comprising a bevelled flange defining an opening for receiving a shaft of the radial impeller, the bevelled flange comprising a non-convex profile.
27. The apparatus of example 26, further comprising the blades, wherein the blades are arranged radially around the bevelled flange.
28. The apparatus of any one of examples 26 to 27, wherein the bevelled flange is shaped to comprise a concave or linear cross-sectional profile.
29. The apparatus of any one of examples 26 to 28, further comprising a disk connecting the blades to the beveled flange, wherein the bevel of the beveled flange covers at least a portion of a surface of the disk between the hub and the blades.
30. The apparatus of any one of examples 26 to 29, wherein the bevelled flange extends past the inner edge of the blades.
31. The apparatus of any one of examples 26 to 30, wherein the blades are perpendicular to their rotational plane, or at an angle to their rotational plan.
32. The apparatus of any one of examples 26 to 31, wherein the blades are in contact with the bevel.
33. The apparatus of any one of examples 26 to 32, wherein the blades are flat, curved, scooped, forward swept, or back swept.
34. The apparatus of any one of examples 26 to 33, further comprising an upper impeller defining an open for receiving the shaft, the upper impeller positioned a distance above the blades to increase downward fluid velocity against the bevel.
35. The apparatus of any one of examples 26 to 34, further comprising a complementary bevel extending from another location on the centerline of the shaft toward the inner edge of the blades, wherein the complementary bevel commences on an opposite side of a rotational plane of the blades as the bevel.
36. The apparatus of any one of examples 26 to 35, the bevel further comprising a protective coating for inhibiting abrasion or a non-stick coating.
37. A method for operating a Rushton impeller in a fluid, the method comprising:
   rotating the impeller to induce axial movement in the fluid; and
   providing a non-convex profile in a region between a centreline of the impeller and blades of the impeller;
   wherein rotating the impeller causes the profile to inhibit low velocity movement of the fluid directly above the region.
38. The method of example 37, further comprising providing a bevel between a centreline of the hub and the blades of the impeller.
39. The method of any one of examples 37 to 38, wherein the bevel is shaped to comprise a concave or a linear cross-sectional profile.
40. The method of any one of examples 37 to 39, further comprising a flange or a sheet configured to provide the bevel.
41. An agitator comprising:
   a motor;
   a shaft configured to be driven by the motor; and
   a Rushton impeller connected to the shaft, the Rushton impeller according to any one of examples 1 to 25.
42. The agitator of example 41, wherein the bevel is affixed to the shaft using a hub.
43. The agitator of examples 41 or 42, wherein the bevel is shaped to comprise a concave or a linear cross-sectional profile.
44. The agitator of any one of examples 41 to 43, further comprising a flange or a sheet configured to provide the bevel.
45. The agitator of any one of examples 41 to 44, wherein the bevel is mechanically fastened to the hub or welded to the hub.
46. The agitator of any one of examples 41 to 45, wherein the bevel is an assembly of one or more pieces.
47. The agitator of any one of examples 41 to 46, further comprising a disk connecting the blades to the hub, wherein the bevel covers at least a portion of a surface of the disk between the hub and the blades.

## Claims

1. A Rushton impeller comprising:
a hub;
blades radially distributed about the hub for rotating about a centreline of the impeller to move a fluid radially, the blades having an inner edge spaced a distance from a centerline of the impeller; and
a non-convex bevel between the hub and the blades, the bevel encircling the centreline of the impeller and rotating with the blades.

2. The Rushton impeller of claim 1, wherein the non-convex bevel extends from the hub toward the blades.

3. The Rushton impeller of claims 1 or 2, wherein all the blades are the same size and shape.

4. The Rushton impeller of any one of claims 1 to 3, wherein the bevel extends from the hub to the blades.

5. The Rushton impeller of any one of claims 1 to 4, wherein the bevel is at an obtuse angle to a shaft or the hub.

6. The Rushton impeller of any one of claims 1 to 5, wherein the bevel affixes the blades to the hub.

7. The Rushton impeller of any one of claims 1 to 6, further comprising an upper impeller positioned a distance above the blades to increase downward fluid velocity against the bevel.

8. The Rushton impeller of any one of claims 1 to 7, further comprising a complementary bevel extending from another location of the centerline of the hub toward the blades, wherein the complementary bevel is on an opposite side of a rotational plane of the blades as the bevel.

9. An apparatus for a radial impeller comprising blades configured to induce a radial flow of a fluid, the apparatus comprising a bevelled flange defining an opening for receiving a shaft of the radial impeller, the bevelled flange comprising a non-convex profile.

10. The apparatus of claim 9, further comprising an upper impeller defining an open for receiving the shaft, the upper impeller positioned a distance above the blades to increase downward fluid velocity against the bevel.

11. The apparatus of claim 10, further comprising a complementary bevel extending from another location on the centerline of the shaft toward the inner edge of the blades, wherein the complementary bevel commences on an opposite side of a rotational plane of the blades as the bevel.

12. A method for operating a Rushton impeller in a fluid, the method comprising:
rotating the impeller to induce axial movement in the fluid; and
providing a non-convex profile in a region between a centreline of the impeller and
blades of the impeller;
wherein rotating the impeller causes the profile to inhibit low velocity movement of the fluid directly above the region.

13. An agitator comprising:
a motor;
a shaft configured to be driven by the motor; and
a Rushton impeller connected to the shaft, the Rushton impeller according to any one of claims 1 to 11.

14. The agitator of claim 13, wherein the bevel is mechanically fastened to the hub or welded to the hub.

15. The agitator of claim 14, further comprising a disk connecting the blades to the hub, wherein the bevel covers at least a portion of a surface of the disk between the hub and the blades.
